# EUROPEAN PATENT APPLICATION

(11) **EP 4 769 199 A1**
(43) Date of publication of application: **01.07.2026**
(21) Application number: 24915047.5
(22) Date of filing: 02.12.2024
(51) Int. Cl.: G06F 30/10, H05B 47/10

(54) **AMBIENT LIGHTING DEVICE, LIGHT-EMITTING ZONE LAYOUT AND CONSTRUCTION AND GENERATION METHODS THEREFOR**

(30) Priority: 04.01.2024 CN 202410013407; 04.01.2024 CN 202410013391
(71) Applicant: Shenzhen Intellirocks Tech. Co., Ltd., Shenzhen, Guangdong 518055 (CN); Shenzhen Qianyan Technology Ltd., Shenzhen, Guangdong 518055 (CN)
(72) Inventor: QIN, Tao, Shenzhen, Guangdong 518055 (CN); LUO, Quanshuang, Shenzhen, Guangdong 518055 (CN); WU, Wenlong, Shenzhen, Guangdong 518055 (CN)
(74) Representative: Wang, Bo
(86) International application number: PCT/CN2024/136088
(87) International publication number: WO 2025/145831

(57) **Abstract**

An ambient lighting device, a light-emitting zone layout construction method and apparatus, a computer device, a computer-readable storage medium, and a computer program product. The method comprises: determining a contour path of a light-emitting light strip and a plurality of lamp positions in the contour path on the basis of a light strip image (S5100); constructing a light strip model representing the contour path and the lamp positions, and displaying the light strip model in an interface canvas for user editing (S5200); and in response to a layout construction instruction, constructing sequence position information of the lamp positions determined by referring to the interface canvas within the light strip model as a light-emitting zone layout of the light-emitting light strip (S5500).

## Description

### TECHNICAL FIELD

The present application relates to the field of lighting control, and in particular, to an ambient light device, a method for constructing a light-emitting zone layout, a device, a computer device, a computer-readable storage medium, and a computer program product.

### BACKGROUND ART

In an ambient light device, a light-emitting strip is adopted as the light body responsible for light emission and atmosphere rendering. Since the light-emitting strip possesses flexibility, the light-emitting strip can be bent and shaped into various desired shapes, such as flowers, clouds, or other patterns. When it is necessary to play a corresponding lighting effect via the light-emitting strip, the lighting effect can provide a color distribution based on materials such as reference images; the color distribution is projected onto the light-emitting strip, and the corresponding lighting effect is played collaboratively by each of the light-emitting units in the light-emitting strip to display the corresponding color distribution, thereby achieving the effect of light atmosphere rendering.

To support the projection of the color distribution onto the light-emitting strip, it is necessary to know the position distribution of the light-emitting units in the light-emitting strip on a pattern plane formed by the light-emitting strip. When the color distribution needs to be projected, the projection can be realized by referring to this position distribution. The manner of determining this position distribution is usually realized by means of manual design, and the efficiency is obviously low.

### SUMMARY OF THE INVENTION

The objective of the present application is to provide an ambient light device, a method for constructing a light-emitting zone layout, a device, a computer device, a computer-readable storage medium, and a computer program product.

According to one aspect of the present application, a method for constructing a light-emitting zone layout is provided. The method includes: determining, based on a light strip image, a shaping path of a light-emitting strip and a plurality of light positions in the shaping path; constructing a light strip model representing the shaping path and each of the light positions, and displaying the light strip model on an interface canvas for user editing; and constructing, in response to a layout construction instruction, sequential position information of each of the light positions determined in the light strip model with reference to the interface canvas as a light-emitting zone layout of the light-emitting strip.

According to one aspect of the present application, a method for constructing a light-emitting zone layout is provided. The method includes: constructing, based on a light strip image, a light strip model representing a shaping path of a light-emitting strip in the light strip image and each of light positions in the shaping path, and displaying the light strip model on an interface canvas; determining, in response to a light position calibration instruction, light positions designated by the instruction as valid light positions; and constructing, in response to a layout generation instruction, sequential position information of each of the valid light positions determined in the light strip model with reference to the interface canvas as a light-emitting zone layout of the light-emitting strip.

According to another aspect of the present application, an ambient light device is provided. The ambient light device includes a controller and at least one light-emitting strip. The controller is configured to receive a light-emitting zone layout generated by the method for constructing a light-emitting zone layout, and control the light-emitting strip to play a lighting effect based on the light-emitting zone layout.

According to another aspect of the present application, a computer device is provided. The computer device includes a central processing unit and a memory. The central processing unit is configured to invoke and run a computer program stored in the memory to perform steps of the method for constructing a light-emitting zone layout.

According to another aspect of the present application, a non-volatile readable storage medium is provided. The non-volatile readable storage medium stores a computer program in a form of computer-readable instructions, and the computer program, when invoked and run by a computer, causes the computer to perform steps of the above method.

According to another aspect of the present application, a computer program product is provided. The computer program product includes a computer program, and the computer program, when run by a processor, causes the processor to perform steps of the above method.

### BRIEF DESCRIPTION OF THE DRAWINGS

FIG. 1 is a schematic diagram of an electrical structure of an exemplary ambient light device according to the present application, where a light-emitting strip of the ambient light device is shaped into a kettle to indicate that the light-emitting strip can be shaped into any shape;
FIG. 2 is a schematic flowchart of a method for constructing a light-emitting zone layout according to one embodiment of the present application;

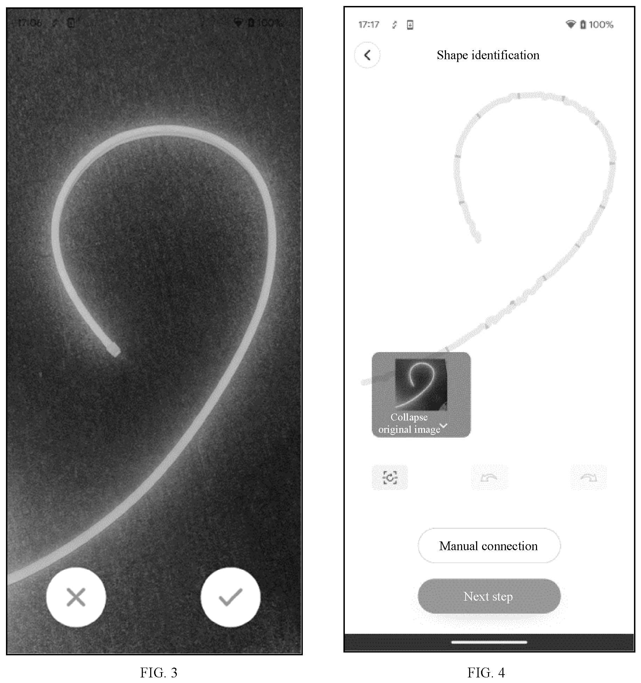

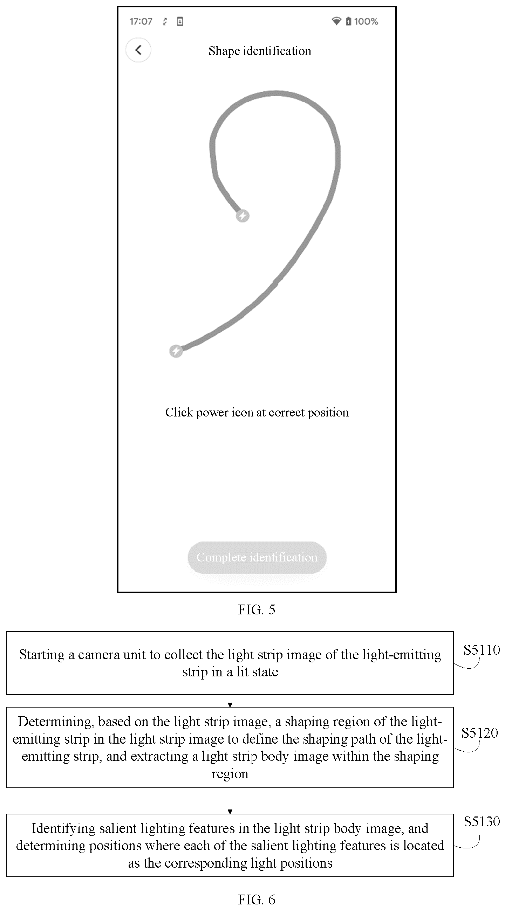

FIGS. 3, 4, and 5 are all exemplary graphical user interfaces, where FIG. 3 shows a camera preview interface to display a light strip image; FIG. 4 shows a light strip model located in an interface canvas, the light strip model indicating a shaping path of the light-emitting strip shown in FIG. 3 and each of light positions in the shaping path; and FIG. 5 shows a manual shaping path confirmed by a user's connection after entering a manual editing mode corresponding to manual connection based on the light strip model of FIG. 4, where light positions covered by the shaping path are confirmed as valid light positions via the shaping path;
FIG. 6 is a schematic flowchart of determining a shaping path and each of light positions based on a light strip image according to an embodiment of the present application;
FIG. 7 is a schematic flowchart of constructing and displaying a light strip model according to an embodiment of the present application;
FIG. 8 is a schematic flowchart of constructing a light-emitting zone layout according to an embodiment of the present application;
FIG. 9 is a schematic flowchart of a method for constructing a light-emitting zone layout according to another embodiment of the present application;

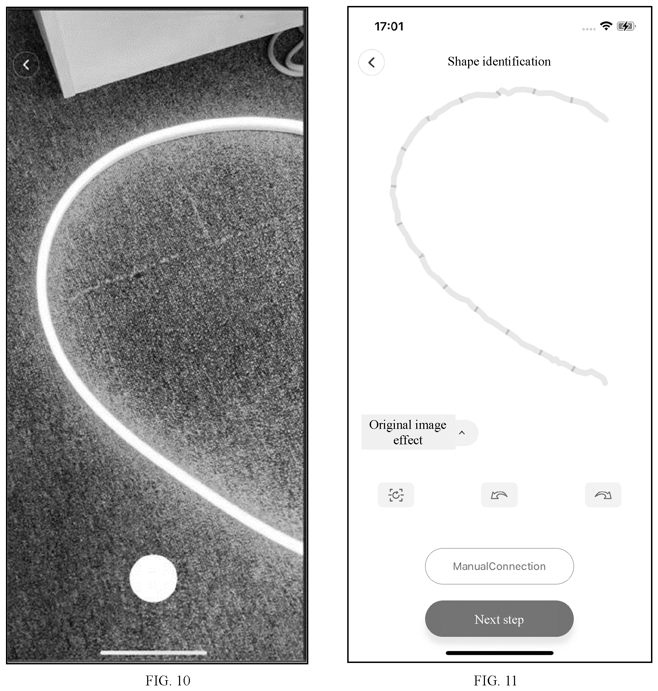

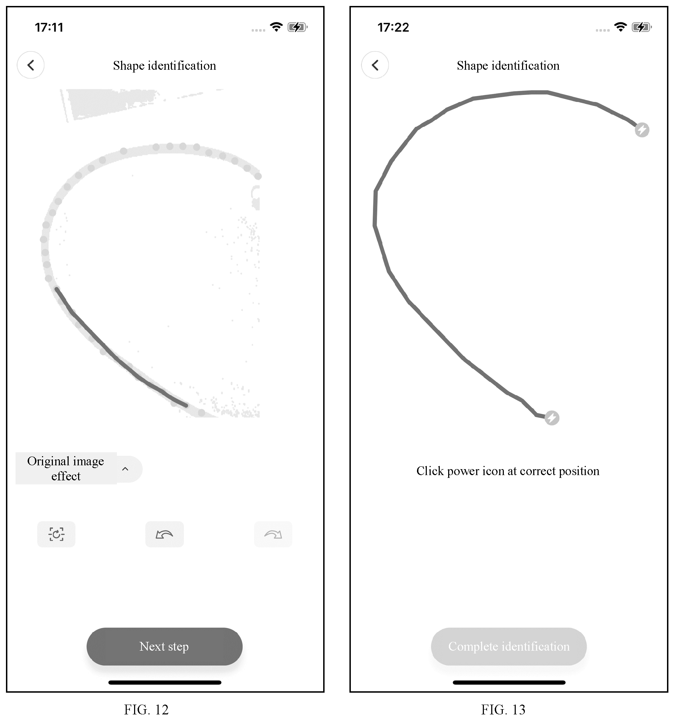

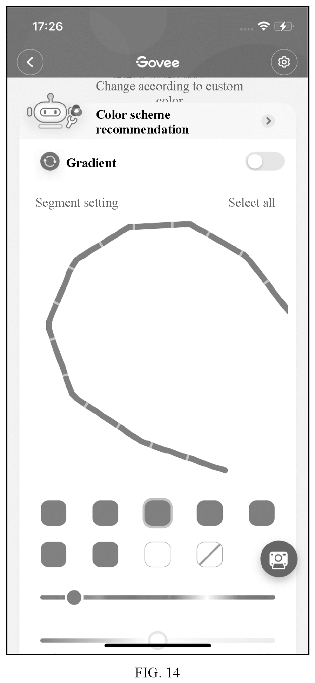

FIGS. 10, 11, 12, 13, and 14 are all exemplary graphical user interfaces, where FIG. 10 shows a camera preview interface to display a light strip image; FIG. 11 shows a light strip model located in an interface canvas, the light strip model indicating a shaping path of the light-emitting strip shown in FIG. 3 and each of light positions in the shaping path; FIG. 12 shows a manual shaping path confirmed by a user's connection after entering a manual editing mode corresponding to manual connection based on the light strip model of FIG. 11, where light positions covered by the manual shaping path are confirmed as valid light positions via the manual shaping path; FIG. 13 shows an effect obtained after completing a line connection of the entire manual shaping path based on FIG. 12, where a user may select any one end in the manual shaping path as a signal input end; and FIG. 14 shows a lighting effect customization interface, where the light strip model is displayed on the lighting effect customization interface for setting a lighting effect for each of the light positions;
FIG. 15 is a schematic flowchart of constructing a light strip model based on a light strip image for display according to an embodiment of the present application;
FIG. 16 is a schematic flowchart of confirming valid light positions in response to a user's connecting operation according to an embodiment of the present application; and
FIG. 17 is a schematic structural diagram of a computer device according to an embodiment of the present application.

### DESCRIPTION OF EMBODIMENTS

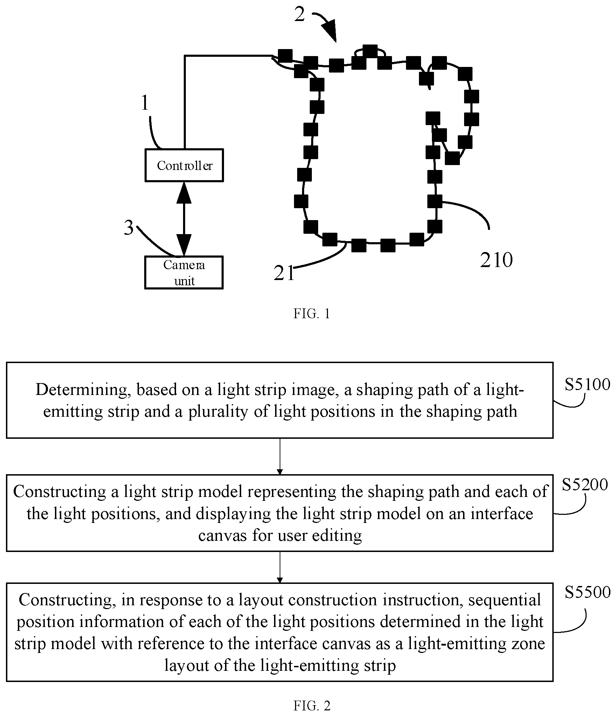

Referring to FIG. 1, it can be seen from a schematic structural diagram of an ambient light device provided according to one embodiment of the present application that the ambient light device includes a controller 1, a light body 2, and an image acquisition interface. The light body 2 is electrically connected to the controller 1 to accept the control of a computer program running in the controller 1 to work cooperatively and realize lighting effect playback.

The controller 1 usually includes a control chip, a communication component, and a bus connector. In some embodiments, the controller 1 may further be configured with a power adapter, a control panel, a display screen, and the like as needed.

The power adapter is mainly configured to convert mains electricity into direct current, so as to supply power to the entire ambient light device. The control chip may be implemented using various embedded chips, such as various types of chips including Bluetooth SoC (System on Chip), WiFi SoC, MCU (Micro Controller Unit), DSP (Digital Signal Processing), and the like. The control chip usually includes a central processing unit and a memory; the memory and the central processing unit are respectively configured to store and execute program instructions to realize corresponding functions. The various types of control chips mentioned above may come with a communication component or be additionally configured with a communication component as needed. The communication component may be configured to communicate with an external device; for example, the communication component may communicate with a terminal device such as a personal computer or various smartphones, so that after a user issues various configuration instructions via their terminal device, the control chip of the controller 1 can receive the configuration instructions via the communication component to complete basic configuration, so as to control the light body to work. In addition, the controller 1 may further acquire an interface image of the terminal device via the communication component, or acquire a real-time preview image collected by a camera unit 3. The bus connector is mainly configured to provide power access to the light body 2 accessing the bus and provide a lighting effect playback instruction, and thus provides pins corresponding to a power bus and a signal bus. In this way, when the light body 2 needs to access the controller 1, the light body only needs to be connected to the bus connector via a corresponding connector of the light body 2. The control panel usually provides one or more keys, which are configured to implement switch control on the controller 1, select various preset lighting effect control modes, and so on. The display screen may be configured to display various control information, so as to cooperate with the keys on the control panel to support the realization of human-machine interaction functions. The control panel and the display screen may be integrated into the same touch display screen.

The light body 2 in the ambient light device is implemented using light-emitting strips, and may include one or more light-emitting strips; since the light-emitting strips possess flexibility, the light-emitting strips can be shaped into a layout of any shape. Each light-emitting strip 21 includes a plurality of LED packages 210 connected in series, with each LED package 210 serving as a light-emitting unit; moreover, the number of LED packages 210 in each light-emitting strip 21 may be the same, and the LED packages are arranged at equal intervals. Working current is transmitted to LED packages 210 in the same light-emitting strip 21 by the same set of cables accessing the bus; in terms of electrical connection relationship, the LED packages 210 of the same light-emitting strip 21 may be connected in a parallel manner.

The image acquisition interface may be either a hardware interface or a software interface implemented in the controller 1. When the image acquisition interface is a hardware interface, the image acquisition interface can be implemented as a camera unit 3, and the controller 1 loads a corresponding driving program to drive the camera unit 3 to work. When the camera unit 3 is aimed at a target scene, for example, aimed at a display desktop of a terminal device, or when the camera unit 3 is aimed at a physical spatial environment and collects images according to a certain frame rate, interface images can be collected. When the image acquisition interface is a software interface, the image acquisition interface may be an image acquisition program implemented on the controller 1 side by utilizing graphics infrastructure technology provided by an operating system of the terminal device. When the controller 1 is connected to the terminal device via various cables such as HDMI and Type-C connecting cables, interface images of the terminal device can be continuously obtained with the support of the graphics infrastructure technology. Certainly, if a wireless screen projection protocol is pre-established between the controller 1 and the terminal device, the controller 1 can also acquire the interface images of the terminal device by means of wireless communication. The graphics infrastructure technology of the operating system varies depending on the type of operating system. For example, in the Windows operating system, a technology, i.e., Microsoft Direct X Graphics Infrastructure (abbreviated as DXGI), is provided, which can realize this function.

Thus, it can be seen that when the image acquisition interface is responsible for collecting an environmental reference image, the specific environment for collecting the image can be flexibly set by a user. For example, when the image acquisition interface is a camera unit 3, the user may aim the camera unit 3 at a graphical user interface of a computer for shooting to collect a corresponding interface image as a target image used for playing a lighting effect, enabling the light body 2 to generate corresponding lighting effect description data based on the interface image; the user may also aim the camera unit 3 at a physical spatial environment, such as an outdoor environment, to record a real scene image as the environmental reference image, enabling the light body 2 to generate lighting effect description data corresponding to the real scene.

When the ambient light device is to play a lighting effect based on the lighting effect description data, the controller 1 of the ambient light device needs to provide sequential position information of each light-emitting unit in the light body 2 of the ambient light device based on a corresponding light-emitting zone layout of the light body 2, so as to parse the corresponding lighting effect description data into control data for each light-emitting unit, encapsulate the respective control data into lighting effect control data based on the sequential position information of each light-emitting unit, and then send the lighting effect control data to the corresponding light-emitting strip; a control chip of each light-emitting unit in the light-emitting strip extracts control data corresponding to the light-emitting unit itself, and controls each light-emitting element therein to emit corresponding colored light based on the control data, thereby realizing the playback of the entire lighting effect under the cooperative action of the colored light emitted by the light-emitting units.

According to the product architecture and working principle of the ambient light device described above, the method for constructing a light-emitting zone layout of the ambient light device according to the present application can be implemented as a computer program product running in a terminal device, which obtains a light-emitting zone layout corresponding to a light-emitting strip by analyzing a light strip image obtained by photographing the light-emitting strip in the ambient light device, and provides the light-emitting zone layout to the controller of the corresponding ambient light device as basic configuration information for playing a lighting effect.

Referring to FIG. 2, in one embodiment of the present application, the method for constructing a light-emitting zone layout according to the present application is applicable to a terminal device adapted to be communicatively connected to the ambient light device of the present application. The method includes the following steps.

In step S5100, a shaping path of a light-emitting strip and a plurality of light positions in the shaping path are determined based on a light strip image.

According to the present application, the shaping path formed after a user shapes the light-emitting strip may be determined based on image analysis performed on the light strip image obtained by photographing the light-emitting strip adopted in a light body in the ambient light device. Meanwhile, the light positions distributed on the shaping path may also be determined during the image analysis. The light position referred to herein is a light-emitting unit used for indicating the shaping path obtained based on the image analysis of the light strip image. The light-emitting unit may be set corresponding to a light-emitting unit in the light-emitting strip, or may be set corresponding to a plurality of light-emitting units of a standard quantity or within a standard length range in the light-emitting strip. Therefore, at a computer program level, the light position may be represented as a section in the shaping path, where each section may correspond to and indicate coverage of one or several light-emitting units; or the light position may be represented as a node in the shaping path, where each node represents only one light-emitting unit in the shaping path. During actual implementation, a selection may be made based on requirements, so as to make zone management of the light-emitting strip more flexible. For ease of understanding, each light position mentioned in the following embodiments of the present application may be regarded as one light-emitting unit in the corresponding light-emitting strip.

There are various modes to determine the shaping path of the light-emitting strip based on the light strip image, and any of the following modes may be selected for implementation.

In one embodiment, image segmentation may be performed based on a single light strip image to obtain an image mask of the light-emitting strip therein. The image mask actually describes a region where the shape of the light-emitting strip in the light strip image is located, that is, a shaping region. Since the shaping region of the light-emitting strip is necessarily linear, the shaping path of the light-emitting strip is also defined by the shaping region. In this embodiment, the light strip image may be an image before the light-emitting strip lights up or after the light-emitting strip lights up. Determining the shaping path in an end-to-end manner according to this mode is more precise.

In another embodiment, binarization conversion may be performed based on a single light strip image, and edge detection may be performed by means of various known edge detection algorithms on the basis of a converted binarized image, thereby obtaining the shaping region to define the shaping path of the light-emitting strip. Similarly, in this embodiment, the light strip image may be an image before the light-emitting strip lights up or after the light-emitting strip lights up. Determining the shaping path according to this mode features a low computational load, rapid identification, and low implementation cost, which is more economical.

In the above two embodiments for determining the shaping path of the light-emitting strip, in order to improve the accuracy of shaping path detection, prior to acquiring the single light strip image, a lighting instruction may be first sent to the ambient light device via the terminal device to cause the ambient light device to first control the light-emitting strip to light up, and then the camera unit is started to obtain the light strip image. Since the light-emitting strip is in a lit state in this case, the light-emitting strip in the obtained light strip image is brighter. Whether performing image segmentation or performing edge detection, the shaping region of the light-emitting strip in the light strip image can be determined more accurately with the aid of the bright feature.

In yet another embodiment for determining the shaping path of the light-emitting strip based on the light strip image, after enabling the camera unit of the terminal device to perform camera preview, two frames of light strip images, before and after the light-emitting strip lights up, may be acquired, and frame difference information is solved after aligning the two light strip images. In the frame difference information, pixels corresponding to a position where the light-emitting strip is located obtain significant numerical values, and a set of pixels having the significant numerical values constitutes the shaping region of the light-emitting strip, thereby defining the shaping path. This mode similarly has the advantages of a low computational load, fast speed, and high efficiency.

FIGS. 3 and 11 are light strip images obtained by photographing a light-emitting strip of an ambient light device in an exemplary scenario. The light-emitting strip is in a lit state; therefore, the light-emitting strip in the light strip image is relatively bright and available for reference.

After the shaping path of the light-emitting strip is determined, the light positions distributed on the shaping path can be further detected. There are also multiple modes to determine the light positions on the shaping path, and any of the following modes may be selected for implementation.

In one embodiment, implementation can be performed according to the following process: calculating an actual size corresponding to the light strip image in a physical space based on an imaging focal length of the light strip image; then, calculating a length of the shaping path based on a shaping region in the light strip image as an actual size of the light-emitting strip; and finally, segmenting the shaping path based on a preset zone occupancy parameter, where each segment constructs one corresponding light position. The zone occupancy parameter may be a spacing between two adjacent light-emitting units in the light-emitting strip, or may be a total number of light-emitting units of the light-emitting strip. By evenly dividing the actual size based on the spacing or the total number, each section can be determined, thereby determining each of the light positions. The zone occupancy parameter may further be used to indicate a standard quantity of light-emitting units constituting one light position, and the division setting can be performed by treating one group of light-emitting units of the standard quantity as one light position. According to this embodiment, in the case where the zone occupancy parameter is preset, each of the light positions in the light strip image can be automatically determined without relying on whether the light-emitting strip is lit. An algorithm for determining the light positions is determined in association with a physical focal length of imaging, which is relatively accurate, requires no manual intervention, and is more efficient. The zone occupancy parameter may be preset by a user or utilize a factory default setting provided by an application.

In another embodiment, implementation can be performed according to the following process: first, sending a specific lighting instruction to the ambient light device to control each of the light-emitting units of the light-emitting strip to operate at high brightness with a specific color distribution, causing two adjacent light-emitting units to display different colors; and in the light strip image, dividing, along the shaping path of the light-emitting strip, the shaping path into a plurality of sections based on different characteristics of the light radiated by adjacent light-emitting units; each section constitutes one corresponding light position. Determining the light positions according to this mode does not need to rely on the zone occupancy parameter and thus possesses more flexible applicability; that is, determining the light positions is not constrained by factors such as the length of the light-emitting strip and the spacing between the light-emitting units. Regardless of how long the length of the light-emitting strip is, or how much the spacing between the light-emitting units is, each of the light positions therein can be effectively identified. The specific lighting instruction used herein may further be used in combination with the embodiment described above regarding the determination of the shaping path using an image of the light-emitting strip after lighting up. That is, controlling the light-emitting strip to light up via the specific lighting instruction at a first time to obtain the light strip image after lighting up can be used for both determining the shaping path and determining the light positions in this embodiment. It can be seen that this embodiment can possess an efficiency advantage of organic combination with the embodiment described above regarding the determination of the shaping path using the image after lighting up.

In step S5200, a light strip model representing the shaping path and each of the light positions is constructed, and the light strip model is displayed on an interface canvas for user editing.

After the shaping path and each of the light positions of the light-emitting strip in the light strip image are determined, the shaping path and each of the light positions can be migrated and represented in a graphical user interface of a terminal device, so that the user can edit the light positions in the graphical user interface by means of the human-machine interaction capability of the terminal device.

To this end, as shown in FIGS. 4 and 11, an interface canvas may be first set in the graphical user interface, thereby defining a reference coordinate system; then, the shaping path is constructed as a light strip model and is positioned and displayed on the interface canvas, being displayed in a relatively overall centered manner to obtain a better visual effect. Meanwhile, when the light strip model is constructed, the light positions distributed along the shaping path are also marked at corresponding positions; that is, a visual identifier is displayed for each of the light positions in the shaping path represented by the light strip model. In this way, by means of the light strip model on the interface canvas, the visual representation of the shaping path and each of the light positions of the light-emitting strip in the light strip image is realized, and the user can browse a full view of the light strip model through the interface canvas and can perform operations such as scaling, translating, and editing on the light strip model.

FIG. 4 is an example of the light strip model displayed on the interface canvas after determining the shaping path and the light positions based on the light strip image shown in FIG. 3. In the interface shown in FIG. 4, the shaping path of the light-emitting strip is displayed as gray, and each light position in the shaping path is shown as a visual identifier using a light-colored dot. Below the light strip model, a light strip image browsing key is provided for displaying or hiding the light strip image shown in FIG. 3, that is, the light strip image used to determine the light strip model, facilitating user reference. Below the light strip model, a key corresponding to "Manual Connection" is further provided for switching to a user manual editing mode, so that the user can confirm valid light positions among a plurality of light positions of the light strip model for constructing a light-emitting zone layout in step S5500. When the user clicks the "Next" key below without touching the "Manual Connection" key to enter the manual editing mode, each light position on the light strip model in the interface shown in FIG. 4 will be defaulted as a valid light position used for constructing the light-emitting zone layout in step S5500.

Referring to FIG. 4, it can be seen that the user may perform a manual editing operation based on the light strip model to confirm each light position in the light-emitting strip, so as to enter an interface shown in FIG. 5. In the interface, for example, the user may manually connect a plurality of valid light positions therein with a line to indicate confirmation. The connection by the user constitutes a de facto manual shaping path. Light positions covered by the manual shaping path constitute valid light positions, and light positions not covered by the manual shaping path are invalid light positions, thereby excluding the invalid light positions from the connection line. In this process, the user may supplement the same connection multiple times until a desired connection state is reached. When the user releases a connecting action in each connecting operation, a corresponding light position calibration instruction may be triggered. In response to the instruction, the terminal device confirms light positions connected by the line as valid light positions, regards light positions not covered by the connection line as invalid light positions, and subsequently performs corresponding processing only on the valid light positions when constructing the light-emitting zone layout, without performing processing on the invalid light positions.

In step S5500, in response to a layout construction instruction, sequential position information of each of the light positions determined in the light strip model with reference to the interface canvas is constructed as a light-emitting zone layout of the light-emitting strip.

When the user considers that the distribution relationship of the light positions in the light strip model is accurate, the layout construction instruction may be triggered in the terminal device. A triggering mode of the layout construction instruction may be based on the key provided in the graphical user interface, for example, triggering the instruction by touching the "Complete Identification" control key in the interface shown in FIG. 5, or the instruction may be generated by means of any designated control mode, such as other gesture operations, shaking, or voice instructions.

In response to the layout construction instruction, the terminal device determines position information of each light position using the interface canvas as the reference coordinate system, determines sequence information of each light position using the shaping path of the light strip model as the sorting basis, jointly represents the sequence information and the position information of each light position as sequential position information, and encapsulates the sequential position information of each light position according to a preset protocol format to constitute description information of the distribution relationship of each light position in the light-emitting strip, thereby forming the light-emitting zone layout.

The light-emitting zone layout determined in the present application may be stored in a cloud server or stored locally in a terminal device for subsequent invocation. For example, when the lighting effect of the ambient light device needs to be edited, the light-emitting zone layout may be utilized to regenerate the light strip model of the light-emitting strip, so as to enable a user to set colors for the light positions, configure lighting effect movement modes, and the like based on the light strip model. The terminal device may further transmit the light-emitting zone layout to the controller of the ambient light device to serve as basic information for the controller to play the lighting effect. After the controller stores the light-emitting zone layout, upon receiving lighting effect description data, the controller parses and converts the lighting effect description data into a plurality of playback frames. Corresponding to each playback frame, the controller generates corresponding control data based on the light-emitting units corresponding to the light positions at respective sequential positions designated in the light-emitting zone layout, encapsulates the control data of all the light-emitting units as lighting effect control data, and transmits the lighting effect control data to the light-emitting strip. The light-emitting units in the light-emitting strip extract control data corresponding to the respective light-emitting units themselves from the lighting effect control data, and control corresponding light-emitting elements of the respective light-emitting units themselves to emit corresponding colored light. Accordingly, each of the light-emitting units in the entire light-emitting strip collaboratively plays the same frame of the lighting effect; furthermore, by playing the plurality of playback frames, the playing of the same motion lighting effect can also be realized.

It can be understood from the above embodiments that the present application adapts to the characteristic that the light-emitting strip possesses flexibility and is shapeable. Based on a light strip image, a shaping path of the light-emitting strip is directly determined, and a plurality of light positions in the shaping path are simultaneously determined. A light strip model corresponding to the light-emitting strip is constructed based on the shaping path and each of the light positions, and the light strip model is displayed on an interface canvas. This realizes the abstraction of the light-emitting strip into a graphic object in a graphical user interface, as well as the indication of each light position in the graphical user interface, so as to enable a user to edit and correct the light positions. When the user triggers a layout construction instruction, in response to the instruction, sequential position information of each light position in the light strip model is encapsulated into a light-emitting zone layout. With the interface canvas serving as a reference plane, the sequential position information of each light position is accurately represented, so that the light-emitting zone layout accurately describing the position distribution of each light position can be obtained. The light-emitting zone layout may be provided for the use by the controller of the ambient light device where the light-emitting strip is located. When the controller plays a lighting effect, the controller can determine the sequential position information of each light position of the light-emitting strip based on the light-emitting zone layout, and accurately project the lighting effect based on the sequential position information. The present application has realized an easy-to-understand and easy-to-operate human-machine interaction function for constructing the light-emitting zone layout for the light-emitting strip, which can improve the configuration efficiency of the light-emitting strip and make this type of ambient light device easier to promote and popularize.

Based on any embodiment of the method of the present application, referring to FIG. 6, determining, based on the light strip image, the shaping path of the light-emitting strip and the plurality of light positions in the shaping path includes the following steps.

In step S5110, a camera unit is started to collect the light strip image of the light-emitting strip in a lit state.

In the present application, the image obtained by photographing the light-emitting strip after the light-emitting strip is lit, that is, the light strip image, can be utilized to quickly detect the shaping path and each of the light positions of the light-emitting strip in the light strip image. To this end, in the state where the light-emitting strip of the ambient light device is lit, the camera unit of the terminal device can be started to photograph the light-emitting strip in the lit state to obtain the corresponding light strip image.

In one embodiment, when a user invokes the camera unit in the terminal device for collecting the light strip image, a lighting instruction is automatically sent to the ambient light device in the background. After the controller of the ambient light device receives the lighting instruction, the controller controls the light-emitting strip to light up and work. The lighting instruction may contain light-emitting feature information indicating that adjacent light-emitting units of the light-emitting strip display different colors and the like. The controller converts the light-emitting feature information into control data for each light-emitting unit to constitute lighting effect control data, and sends the lighting effect control data to each light-emitting unit of the light-emitting strip, thereby ensuring that colored lights emitted by two adjacent light-emitting units are different, for example, causing the light-emitting strip to emit light in an order of red, green, blue, red, green, blue...

After the terminal device issues the lighting instruction, the camera unit is started to collect image data, and preview images are obtained in the background. Then, target identification or instruction feature detection is performed on each preview image; when one of the preview images contains the light-emitting strip, the user can be reminded to photograph to acquire the light strip image. When performing the target identification, the target identification can be implemented by means of a target detection model; when performing the instruction feature detection, it can be detected whether a light-emitting feature corresponding to the light-emitting feature information set in the lighting instruction exists in the light strip image. When the light-emitting feature corresponding to the light-emitting feature information exists in the light strip image, the user can be reminded to photograph. In this embodiment, by means of a background identification mechanism, the user can be assisted in confirming whether the light strip image is suitable for determining the shaping path. If the image of the light-emitting strip body in the light strip image is incomplete, or the focus is blurred, causing the background to be unable to determine the light-emitting strip, the user will not be prompted to photograph; in this case, the user can be guided to acquire a valid light strip image.

Certainly, in some other embodiments, the user can independently control the ambient light device to light up the light-emitting strip thereof, and then the user uses the terminal device to perform manual photographing to obtain the light strip image of the light-emitting strip. In some other embodiments, the terminal device can make the lighting instruction available for the user to invoke, which is triggered by the user on demand through a triggering mode such as a control key in a graphical user interface.

In step S5120, a shaping region of the light-emitting strip in the light strip image is determined based on the light strip image to define the shaping path of the light-emitting strip, and a light strip body image within the shaping region is extracted.

For the light strip image obtained in the lit state, since the light-emitting strip is in the lit state, the light-emitting strip region in the light strip image is relatively bright and easier to identify. In this case, as disclosed in the above various embodiments, edge detection or image segmentation technology can be utilized to perform detection on the light strip image, to determine an image content region of the light-emitting strip in the light strip image, that is, the corresponding shaping region presenting the shape of the light-emitting strip. The shaping region may be represented as an image mask. In the image mask, corresponding to the light strip image, pixels covered by the image of the light-emitting strip are represented as 1, and pixels uncovered by the image of the light-emitting strip are represented as 0. As a result, a region constituted by a set of pixels with a numerical value of 1 is the shaping region. Since the light-emitting strip is linear as a whole, the shaping region is inevitably linear, which actually defines the shaping path of the entire light-emitting strip.

In addition, to facilitate centralized identification of the light positions, further based on the shaping region, such as the image mask, all pixels within the shaping region can be extracted from the light strip image to constitute the light strip body image; this is equivalent to removing, based on the light strip image, all background images outside the light-emitting strip to obtain a pure light strip body image.

In step S5130, salient lighting features in the light strip body image are identified, and positions where each of the salient lighting features is located are determined as the corresponding light positions.

In the state where the light-emitting strip emits light, if the light of the light-emitting units thereof is not softened, in the light strip body image, positions corresponding to the light-emitting units should be the brightest parts, constituting the salient lighting features. Even if the light of the light-emitting units in the light-emitting strip is subjected to softening processing by an optical path structure in the light-emitting strip, the positions corresponding to the light-emitting units can still be determined by means of the salient lighting features represented by the light-emitting feature information set in the lighting instruction. Thus, it can be seen that as long as the salient lighting features needed to be identified are determined based on an actual situation, and each of the salient lighting features is identified in the light-emitting strip, the position of each of the salient lighting features can be set as a corresponding light-emitting unit, and each light-emitting unit is taken as a corresponding light position.

Taking the light-emitting feature of alternating red, green, and blue colors exemplified above as an example, color value differences of the three colors of red, green, and blue are distinct; therefore, standard values of the three colors of red, green, and blue are directly used as a reference to identify positions of the respective maximum values of red, green, and blue color sections on the shaping path of the light-emitting strip in the light strip body image as the salient lighting features; these positions are positions where the light-emitting units are located, that is, constituting the corresponding light positions.

In other examples, even if the light-emitting strip emits monochromatic light, it is also possible to detect a bright region in each region of the shaping path; because the bright region is usually the region where the light-emitting unit is located, the bright region can also be taken as the salient lighting feature and set as the corresponding light position.

According to the above embodiments, it can be seen that by utilizing a single light strip image of the light-emitting strip in the lit state, the shaping path of the light-emitting strip and the light positions distributed on the shaping path can be determined in one go. Compared with identifying a light body by employing a plurality of images, this solution possesses technical advantages of a low computational load and rapid and efficient detection, requires no manual intervention, and reduces the difficulty for a user to configure the ambient light device.

Based on any embodiment of the method of the present application, determining, based on the light strip image, the shaping region of the light-emitting strip in the light strip image to define the shaping path of the light-emitting strip includes the following steps.

In step S5121, the light strip image is input into a preset target detection model to detect a region image of the light-emitting strip in the light strip image.

In this embodiment, target detection can be performed on the light strip image by means of a deep learning model implemented using a Yolo series model or the like. The light strip image is input into the target detection model, and the target detection model predicts a candidate box and a confidence score of the light-emitting strip. The candidate box with the confidence score meeting a preset threshold is taken as a valid selection box of the light-emitting strip, and an image corresponding to the valid selection box is cropped from the light strip image as the region image, so as to remove interference of other background image information.

In step S5122, the region image is input into a preset image segmentation model to identify the shaping region of the light-emitting strip in the region image, to define the shaping path of the light-emitting strip.

The region image is further input into an image segmentation model, such as U-net or SAM, to perform image segmentation on the region image, and an image mask of the light-emitting strip in the region image is obtained by means of the image segmentation. The image mask indicates the positions of pixels of the light-emitting strip in the region image. The image mask is expanded corresponding to the light strip image to form an image mask corresponding to the light strip image. In this image mask, the position of the pixel of the light-emitting strip in the light strip image is similarly indicated by the numerical value of 1, which is equivalent to designating the shaping region of the light-emitting strip in the light strip image, thereby defining the shaping path of the light-emitting strip relative to the light strip image.

In this embodiment, detection of the shaping path is performed on the light strip image by means of deep learning models such as the target detection model and the image segmentation model. The powerful image processing capabilities possessed by the deep learning models are utilized to achieve an end-to-end precise detection effect, reduce the development complexity, and save development costs, while also ensuring that the shaping path of the light-emitting strip is precisely determined.

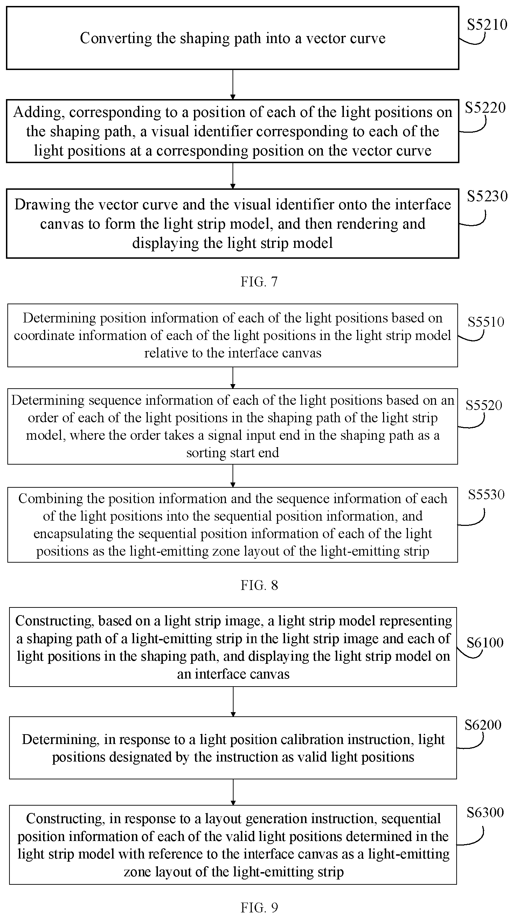

Based on any embodiment of the method of the present application, referring to FIG. 7, constructing the light strip model representing the shaping path and each of the light positions, and displaying the light strip model on the interface canvas for user editing includes the following steps.

In step S5210, the shaping path is converted into a vector curve.

When the light-emitting strip needs to be represented on the interface canvas, since the shaping path of the light-emitting strip has been determined in advance, and the shaping path is represented by the shaping region, the shaping path can accordingly be converted into a vector curve based on the shaping region.

Specifically, the shaping region of the light-emitting strip actually defines a substantially equal-width longitudinal strip-shaped path. Accordingly, along the longitudinal direction of the shaping region, intermediate pixel points between two sides in the width direction of the shaping region on two sides of the path are obtained, and a line connecting these intermediate pixel points can be used to define and describe the shaping path. Further, smoothing processing can be performed on the shaping path to make the shaping path a curve with natural transitions. To facilitate computer processing, the curve can further be converted into a vector curve, and the curve is described by an approximate curve function. Similarly, any long side in the shaping region can be utilized to define the shaping path to obtain a corresponding vector curve. Those skilled in the art can refer to the manner disclosed above for flexible implementation, and details are not described herein again.

In step S5220, corresponding to a position of each of the light positions on the shaping path, a visual identifier corresponding to each of the light positions is added at a corresponding position on the vector curve.

In the present application, the light positions, detected based on the light strip image or the light strip body image therein, are naturally distributed along the shaping path. In this case, a vector curve corresponding to the shaping path may also be taken as a basis, and corresponding to the position of each of the light positions in the shaping path, the detected light positions are marked at the corresponding positions on the vector curve. For ease of identification, each of the light positions may be represented in any visual form, such as a dot or a short line segment, to constitute a visual identifier, so that the visual identifier can be displayed on the interface canvas along with the vector curve.

In step S5230, the vector curve and the visual identifier are drawn onto the interface canvas to form the light strip model, and then the light strip model is rendered and displayed.

After the graphical description data of the light strip model is constructed from the vector curve and the visual identifier of each of the light positions, an image rendering interface of a graphics open library of a system can be invoked. Based on the graphical description data, a GPU is utilized to perform image drawing, to draw the vector curve and the visual identifier onto the interface canvas for rendering and display.

When scaling, translating, or modifying the vector curve or any of the light positions is required, only the graphical description data needs to be correspondingly modified, so that an image effect of the light strip model in the interface canvas can be synchronously updated. Since the light strip model is represented by the graphical description data in the background and belongs to vector data, resource occupation is low, refreshing is efficient, and operations such as scaling, translation, and modification are more convenient to perform.

It can be seen from the above embodiments that when constructing the light strip model corresponding to the light-emitting strip, the shaping path of the light-emitting strip in the light strip image is first constructed as a vector curve, and each of the light positions on the shaping path is configured as a visual identifier at a corresponding position on the vector curve, so as to constitute graphical description information of the light strip model. Then, drawing and rendering are performed for display on the interface canvas. This can further support various editing operations on the light strip model, including scaling, translation, addition, deletion, and modification, which is conducive to ensuring a precise construction of the light-emitting zone layout by the user.

Based on any embodiment of the method of the present application, referring to FIG. 8, constructing the sequential position information of each of the light positions determined in the light strip model with reference to the interface canvas as the light-emitting zone layout of the light-emitting strip includes the following steps.

In step S5510, position information of each of the light positions is determined based on coordinate information of each of the light positions in the light strip model relative to the interface canvas.

After the user triggers the layout construction instruction, the terminal device can determine the position information of each light position in the light strip model on the interface canvas. In this embodiment, the light positions processed are valid light positions in the interface canvas. In the case where the user does not modify the light positions on the light strip model displayed by the terminal device, the light positions on the light strip model are all valid light positions. In an embodiment where the user modifies each light position in the light strip model, for example, the user discards one or several light positions therein using a connection line, in this case, light positions selected by the user using the connection line can be taken as valid light positions, light positions that are not connected can be taken as invalid light positions, and position information is determined only for the valid light positions selected by the user using the connection line.

When determining the position information of the light positions, the position information of each light position can be determined based on the reference coordinate system established for the interface canvas, and corresponding coordinates can be provided to represent the position information. Certainly, the representation may also be replaced by other modes serving the same function.

In step S5520, sequence information of each of the light positions is determined based on an order of each of the light positions in the shaping path of the light strip model, where the order takes a signal input end in the shaping path as a sorting start end.

Similarly, for each light position, specifically for each valid light position for which position information needs to be determined, sequence information thereof in the shaping path needs to be further determined. To this end, any end of the shaping path, that is, any end of the light-emitting strip, may be taken as the sorting start end, and the sequence information of each light position can be determined based on the distance of each light position from the sorting start end. In some embodiments, in the case where the signal input end of the light-emitting strip is determined in advance, the signal input end can be taken as the sorting start end of the shaping path to determine the sequence information of each light position with reference to the sorting start end.

The signal input end of the light-emitting strip may be set in advance by the user via the graphical user interface; for example, in one embodiment, after step S5200, any one of two endpoints in the shaping path on the light strip model of the interface canvas may be selected by the user as the signal input end. In other embodiments, the signal input end on the shaping path may also be determined by means of automatic identification.

In step S5530, the position information and the sequence information of each of the light positions are combined into the sequential position information, and the sequential position information of each of the light positions is encapsulated as the light-emitting zone layout of the light-emitting strip.

After determining the position information and the sequence information of each light position, data encapsulation can be performed on the position information and the sequence information of each light position according to a protocol format, mainly a format pre-agreed with a controller, to obtain the corresponding light-emitting zone layout.

In one embodiment, first, taking each light position, specifically referring to a valid light position, as a unit, the position information and the sequence information of the valid light position are represented according to the protocol format, the position information and the sequence information are comprehensively represented as sequential position information, and then the sequential position information of each valid light position is directly combined into the light-emitting zone layout.

In another embodiment, according to the characteristic that the light-emitting units in the light-emitting strip are connected in an orderly manner, the position information of each light position is spliced in an orderly manner based on an order indicated by the sequence information of each light position, thereby allowing the sequence information of each light position to be represented in the splicing order thereof. In this way, the light-emitting zone layout is obtained more efficiently; correspondingly, on the controller side, the position information and the sequence information of each light-emitting unit can also be parsed and obtained quickly and efficiently.

According to the above embodiments, it is not difficult to understand that in the present application, after each light position in the light strip model is determined, the position information of each light position can be determined based on the reference coordinate system provided by the interface canvas, and the corresponding sequence information of each light position can be determined based on the sorting of each light position in the shaping path of the light-emitting strip. By utilizing the sequence information and the position information of each light position, the light-emitting zone layout can be constructed, thereby realizing an accurate and effective representation of the shape of the light-emitting strip on a composition plane, and providing accurate basic data for the ambient light device to play a lighting effect or for the terminal device to define a lighting effect.

Based on any embodiment of the method of the present application, prior to responding to the layout construction instruction, the method includes the following steps.

In step S5400, a signal input end in the shaping path is identified based on the light strip image, and an order of each of the light positions is determined by taking the signal input end as a sorting start end.

In this embodiment, the signal input end of the light-emitting strip can be automatically identified based on the light strip image, to more effectively represent sequence information of each light position in the shaping path. For example:

In one embodiment, the target detection model may be utilized to perform target identification on a specific shape or a specific component, such as a power adapter, in the light-emitting strip within the light strip image, and an end where the specific shape or the power adapter exists is identified as the signal input end.

In another embodiment, according to the embodiment where a lighting instruction is issued to the ambient light device in advance as described above, under an action of the lighting instruction, the light-emitting strip is controlled to light up to present a corresponding light-emitting feature. Accordingly, corresponding to the light-emitting feature information defined by the lighting instruction, identification of the signal input end can be performed based on the light-emitting feature correspondingly represented in the light strip image. Taking the control of each light-emitting unit in the light-emitting strip to sequentially emit three kinds of colored light of red, green, and blue described above as an example, where the red light is a starting point: considering that the light-emitting strip is provided with an even number of LED packages, and the light-emitting unit located at the end and emitting red light is the location where the signal input end is, color values of colored light at two ends of a light strip body image in the light strip image are identified based on the light-emitting feature; when the color value at one end characterizes red, the end is the signal input end.

By performing image identification on the light strip image, the signal input end of the light-emitting strip can be identified, which is used as a basis to determine the sequence information of each light position in the shaping path, so as to further represent the sequential position information of each light position in the light-emitting zone layout. This can reduce manual intervention and provide automation efficiency.

Based on any embodiment of the method of the present application, prior to responding to the layout construction instruction, the method includes the following steps.

In step S5300, in response to a light position calibration instruction, a light position designated by the instruction is determined as a valid light position suitable for determining sequential position information.

Although each light position can be determined by performing detection on the light strip image, sometimes, due to reflection caused by the bending of the light strip, or due to environmental lighting conditions, misidentification may occur when identifying the light positions of the light-emitting strip in the light strip image, resulting in the appearance of visual identifiers of redundant light positions in the light strip model; in this case, a manual editing mode can be made available to a user, allowing the user to enter a manual editing state to manually designate valid light positions among the light positions.

In one embodiment, as shown in FIG. 5, the user may issue a light position calibration instruction by drawing a connection line in the interface canvas, connecting light positions confirmed as valid by the user onto the same line. The terminal device highlights the connection line of the user to facilitate user identification; each light position covered by the connection line of the user constitutes a valid light position used for constructing the light-emitting zone layout. In the process of constructing the light-emitting zone layout in step S5500, the construction of the sequential position information is performed only for the valid light positions designated by the user.

In another embodiment, the user may separately perform the editing operation on the visual identifier of each light position in the light strip model to trigger the light position calibration instruction. An individual light position in the light strip model may be deleted, or the position of the light position in the shaping path may be fine-tuned. Additionally, an individual light position may be added, and then the position of the light position in the shaping path may be adjusted; all such operations are possible. Light positions finally displayed on the light strip model in the interface canvas are all identified as valid light positions used for constructing the light-emitting zone layout.

When the user completes the editing of the light positions, a corresponding layout construction instruction can be triggered based on the graphical user interface to perform the construction of the light-emitting zone layout.

Regarding the execution of this step, when used in combination with step S5400, this step may be executed prior to step S5400 or after step S5400, without affecting the embodiment of the inventive spirit of the present application.

It can be seen from the above embodiments that the light positions on the light strip model can be edited in various ways. On the one hand, the user is enabled to determine valid light positions used for constructing the light-emitting zone layout based on an actual situation of the light-emitting strip; on the other hand, the role of the light strip model in guiding the user to customize the light positions can also be played. Ultimately, position distribution information accurately representing the distribution of each light-emitting unit of the light-emitting strip along a specific shaping path can be obtained, which is represented as the light-emitting zone layout and is used for reference to implement the customization and playback of the lighting effect.

Referring to FIG. 9, in another embodiment of the present application, the method for constructing a light-emitting zone layout according to the present application is applicable to a terminal device adapted to be communicatively connected to the ambient light device of the present application. The method includes the following steps.

In step S6100, based on a light strip image, a light strip model representing a shaping path of a light-emitting strip in the light strip image and each of light positions in the shaping path is constructed, and the light strip model is displayed on an interface canvas.

In step S6200, in response to a light position calibration instruction, light positions designated by the instruction are determined as valid light positions.

Although each light position can be determined by performing detection on the light strip image, sometimes, due to reflection caused by the bending of the light strip, or due to environmental lighting conditions, misidentification may occur when identifying the light positions of the light-emitting strip in the light strip image, resulting in the appearance of visual identifiers of redundant light positions in the light strip model; in this case, a manual editing mode can be made available to a user, allowing the user to enter a manual editing state to manually designate valid light positions among the light positions.

FIG. 11 is an example of the light strip model displayed on the interface canvas after determining the shaping path and the light positions based on the light strip image shown in FIG. 10. In the interface shown in FIG. 11, the shaping path of the light-emitting strip is displayed as gray, and each light position in the shaping path is shown as a visual identifier using a light-colored dot. Below the light strip model, a light strip image browsing key "Original Image Effect" is provided for displaying or hiding the light strip image shown in FIG. 10, that is, the light strip image used to determine the light strip model, facilitating user reference. Below the light strip model, a key corresponding to "Manual Connection" is further provided for switching to a user manual editing mode, so that the user can confirm valid light positions among a plurality of light positions of the light strip model for constructing a light-emitting zone layout. When the user clicks the "Next" key below without touching the "Manual Connection" key to enter the manual editing mode, each light position on the light strip model in the interface shown in FIG. 11 will be defaulted as a valid light position used for constructing the light-emitting zone layout.

Referring to FIG. 11, it can be seen that the user may perform a manual editing operation based on the light strip model to confirm each light position in the light-emitting strip, so as to enter an interface shown in FIG. 12. In the interface, for example, the user may manually connect a plurality of valid light positions therein with a line to indicate confirmation. The connection by the user constitutes a de facto manual shaping path. Light positions covered by the manual shaping path constitute valid light positions, and light positions not covered by the manual shaping path are invalid light positions, thereby excluding the invalid light positions from the connection line. The user may continue the connection line in a single time or multiple times, for example, continuing the connection line from a state in FIG. 12 to supplement into a connection state in FIG. 13, and then submit a confirmation instruction via a "Complete Identification" control key below the interface. In response to the confirmation instruction, the terminal device identifies light positions confirmed by the connection line as valid light positions, regards light positions not covered by the connection line as invalid light positions, and subsequently performs corresponding processing only on the valid light positions when constructing the light-emitting zone layout, without performing processing on the invalid light positions.

Thus, it can be seen that, as shown in FIGS. 12 and 13, the user may issue a light position calibration instruction by drawing a connection line in the interface canvas, connecting light positions confirmed as valid by the user onto the same line. The terminal device highlights the connection line of the user to facilitate user identification; each light position covered by the connection line of the user constitutes a valid light position used for constructing the light-emitting zone layout. In the process of constructing the light-emitting zone layout, the construction of the sequential position information is performed only for the valid light positions designated by the user.

In another embodiment, the user may separately perform the editing operation on the visual identifier of each light position in the light strip model to trigger the light position calibration instruction. In response to the light position calibration instruction, an individual light position designated by the instruction is deleted, or the position of the light position in the shaping path is fine-tuned. In addition, an individual light position may be added, and then the position of the light position in the shaping path may be adjusted; all such operations are possible. Light positions finally displayed on the light strip model in the interface canvas are all identified as valid light positions used for constructing the light-emitting zone layout.

When the user completes the editing of the light positions, a corresponding layout generation instruction can be triggered based on the graphical user interface to perform the construction of the light-emitting zone layout.

According to content disclosed above, it can be seen that making manual light positions available to the user, on the one hand, enables the user to determine valid light positions used for constructing the light-emitting zone layout based on an actual situation of the light-emitting strip, and on the other hand, may also enable the light strip model to play a role in guiding the user to customize the light positions.

In step S6300, in response to a layout generation instruction, sequential position information of each of the valid light positions determined in the light strip model with reference to the interface canvas is constructed as the light-emitting zone layout of the light-emitting strip.

When the user considers that the distribution relationship of the light positions in the light strip model is accurate, the layout generation instruction may be triggered in the terminal device. A triggering mode of the layout generation instruction may be based on the key provided in the graphical user interface, for example, triggering the instruction by touching the "Complete Identification" control key in the interface shown in FIG. 13, or the instruction may be generated by means of any designated control mode, such as other gesture operations, shaking, or voice instructions.

In response to the layout generation instruction, the terminal device determines position information of each light position using the interface canvas as the reference coordinate system, determines sequence information of each light position using the shaping path of the light strip model as the sorting basis, jointly represents the sequence information and the position information of each light position as sequential position information, and encapsulates the sequential position information of each light position according to a preset protocol format to constitute description information of the distribution relationship of each light position in the light-emitting strip, thereby forming the light-emitting zone layout.

The graphical user interface shown in FIG. 14 shows a light strip model displayed in a lighting effect editing interface by performing composition based on the light-emitting zone layout obtained on the basis of FIG. 13. Based on the lighting effect editing interface of FIG. 14, the user can select each valid light position therein, and perform corresponding setting on a light emission parameter of each light position via a parameter setting control provided below the lighting effect editing interface, such as a color control, so that the description information of a corresponding light-emitting unit can be generated. After the user defines various light emission parameters of an entire lighting effect, the terminal device can encapsulate the various light emission parameters as lighting effect description information and send the lighting effect description information to the controller of the ambient light device, and the controller parses the lighting effect description information and plays the lighting effect.

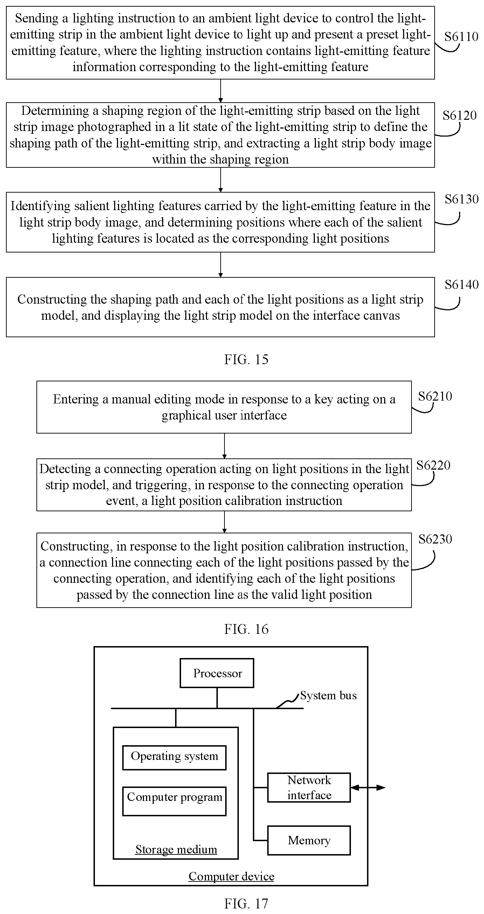

Based on any embodiment of the method of the present application, referring to FIG. 15, constructing, based on the light strip image, the light strip model representing the shaping path of the light-emitting strip in the light strip image and each light position in the shaping path, and displaying the light strip model on the interface canvas includes the following steps.

In step S6110, a lighting instruction is sent to an ambient light device to control the light-emitting strip in the ambient light device to light up and present a preset light-emitting feature, where the lighting instruction contains light-emitting feature information corresponding to the light-emitting feature.

In step S6120, a shaping region of the light-emitting strip is determined based on the light strip image photographed in a lit state of the light-emitting strip to define the shaping path of the light-emitting strip, and a light strip body image within the shaping region is extracted.

When the user confirms in an interface shown in FIG. 10 that the light strip image completely displays a light-emitting strip body, the user can click a confirmation control key in the interface to perform photographing, thereby obtaining the light strip image.

In step S6130, salient lighting features carried by the light-emitting feature in the light strip body image are identified, and positions where each of the salient lighting features is located are determined as the corresponding light positions.

In step S6140, the shaping path and each of the light positions are constructed as a light strip model, and the light strip model is displayed on the interface canvas.

After determining the shaping path and each light position, the light strip model can be constructed according to the various embodiments of implementing the light strip model of the present application. The light strip model represents the shaping path and each light position of the light-emitting strip in the light strip image, and is rendered and displayed on the interface canvas. Generally, the light strip model as a whole can be initialized and positioned in the central region of the interface canvas to facilitate an overall observation by a user.

According to the above embodiments, it can be seen that by sending a lighting instruction to the ambient light device, where light-emitting feature information is carried in the lighting instruction and used for instructing the ambient light device to control the light-emitting strip to light up and present a corresponding light-emitting feature, acquiring a light strip image of the light-emitting strip in a state where the light-emitting strip is lit, and utilizing a single light strip image of the light-emitting strip in the lit state, the shaping path of the light-emitting strip can be identified more conveniently and efficiently with the aid of the light-emitting feature; then, each light position distributed along the shaping path is identified based on the salient lighting feature contained in the light-emitting feature, and the light strip model is constructed based on the shaping path and each light position and displayed on the interface canvas. Throughout the entire process, only the single light strip image is used, so that the shaping path and each light position required for constructing the light strip model can be obtained accurately and efficiently with the aid of the light-emitting feature, which facilitates the implementation using a traditional algorithm with a low computational load, and the entire process can be implemented automatically without manual intervention, effectively reducing the difficulty for a user to configure the ambient light device.

Based on any embodiment of the method of the present application, determining the shaping region of the light-emitting strip based on the light strip image photographed in the lit state of the light-emitting strip to define the shaping path of the light-emitting strip includes the following steps.

In step S5121, the light strip image is input into a preset target detection model to detect a region image of the light-emitting strip in the light strip image.

In this embodiment, target detection can be performed on the light strip image by means of a deep learning model implemented using a Yolo series model or the like. The light strip image is input into the target detection model, and the target detection model predicts a candidate box and a confidence score of the light-emitting strip. The candidate box with the confidence score meeting a preset threshold is taken as a valid selection box of the light-emitting strip, and an image corresponding to the valid selection box is cropped from the light strip image as the region image, so as to remove interference of other background image information.

In step S5122, the region image is input into a preset image segmentation model to identify the shaping region of the light-emitting strip in the region image, to define the shaping path of the light-emitting strip.

The region image is further input into an image segmentation model, such as U-net or SAM, to perform image segmentation on the region image, and an image mask of the light-emitting strip in the region image is obtained by means of the image segmentation. The image mask indicates the positions of pixels of the light-emitting strip in the region image. The image mask is expanded corresponding to the light strip image to form an image mask corresponding to the light strip image. In this image mask, the position of the pixel of the light-emitting strip in the light strip image is similarly indicated by the numerical value of 1, which is equivalent to designating the shaping region of the light-emitting strip in the light strip image, thereby defining the shaping path of the light-emitting strip relative to the light strip image.

Based on any embodiment of the method of the present application, constructing the shaping path and each of the light positions as the light strip model, and displaying the light strip model on the interface canvas may adopt the steps shown in FIG. 7.

Based on any embodiment of the method of the present application, referring to FIG. 16, determining, in response to the light position calibration instruction, the light positions designated by the instruction as the valid light positions includes the following steps.

In step S6210, a manual editing mode is entered in response to a key acting on a graphical user interface.

When a user needs to edit the light position on the light strip model, the user may enter the interface shown in FIG. 5 via the "Manual Connection" control key in the interface shown in FIG. 11, so as to reconnect the shaping path of the light strip model with a line.

In step S6220, a connecting operation acting on light positions in the light strip model is detected, and a light position calibration instruction is triggered in response to the connecting operation event.

In the interface shown in FIG. 12, the terminal device detects, in the background, a connecting operation of the user acting on each light position on the light strip model. The user may select any one of the light positions as a starting light position, and slide to select the next light position, thereby leading out a connection line. As the light positions selected by the user increase, the length of the connection line also increases. The connecting operation of the user may be implemented in multiple times, and the light position corresponding to the starting point of the subsequent connecting operation is configured to be the light position corresponding to the end point of the previous connecting operation, so that the connection line is continuous.

In one embodiment, in the case where the signal input end of the light-emitting strip is determined in advance, the terminal device may further perform data fitting by using position information of other light positions covered by the user's connection prior to the current light position to obtain an approximate curve function, and then determine the distance by which position information of the current light position deviates from the approximate curve function. When the distance exceeds a preset threshold, it is determined that the user's connection direction is incorrect and the current light position is not taken as a selected light position of the connection; when the distance does not exceed the preset threshold, the current light position is taken as the selected light position of the connection, thereby implementing the verification of each current light position passed by the user's connection during the user's connecting operation, and correspondingly confirming the selected or unselected state of the current light position. When a current light position is determined as a selected light position, the segment corresponding to the connection line reaching the current light position in the interface canvas may be displayed in a target color; otherwise, the target color is not displayed in the segment to indicate that the current light position cannot be selected. In this way, navigation is performed on the user's connecting operation process to ensure that the user correctly connects each light position, which can effectively avoid the situation where the user, after selecting a portion of light positions in one segment along the shaping path of the light-emitting strip, returns in a reverse direction to the segment to select other light positions therein, thereby avoiding causing an error in a manual shaping path defined by the user's connection.

After the user selects each target light position and releases a sliding gesture, a connecting operation event can be triggered. In response to the connecting operation event, a light position calibration instruction can be triggered. When the user performs the connecting operation discontinuously for multiple times, the connecting operation event may be correspondingly triggered multiple times, thereby triggering the light position calibration instruction multiple times.

In step S6230, in response to the light position calibration instruction, a connection line connecting each of the light positions passed by the connecting operation is constructed, and each of the light positions passed by the connection line is identified as a valid light position.

The terminal device determines, in response to each light position calibration instruction, each light position selected by the current light position calibration instruction, and identifies these light positions as valid light positions. Since the user is allowed to define a manual shaping path of the light-emitting strip through multiple connecting operations, all valid light positions identified by the multiple connecting operations of the user may be represented as being connected on the same connection line. As shown in FIG. 12, there is only a partial segment of the connection line, and after the user continues performing selection, a more complete connection line is constituted in the interface in FIG. 13.

According to this embodiment, it can be seen that the user can perform the connecting operation on each confirmed light position in the light strip model in the interface canvas by means of a convenient sliding operation gesture, and connect these light positions together by a connection line for the terminal device to identify these light positions as valid light positions; other light positions that are not connected are taken as invalid light positions and no longer participate in the construction of a light-emitting zone layout. Therefore, technical support is provided for the user to confirm the valid light positions, making confirmation of the valid light positions by the user more convenient, which helps to improve the user experience.

Based on any embodiment of the method of the present application, constructing the sequential position information of each valid light position determined in the light strip model with reference to the interface canvas as the light-emitting zone layout of the light-emitting strip may adopt the steps shown in FIG. 8.

Based on any embodiment of the present application, referring to FIG. 17, another embodiment of the present application further provides a computer device. The computer device can function as a controller in the ambient light device. As shown in FIG. 17, a schematic diagram of an internal structure of the computer device is illustrated. The computer device includes a processor, a computer-readable storage medium, a memory, and a network interface, all connected via a system bus. The computer-readable storage medium of the computer device stores an operating system, a database, and a computer program encapsulating computer-readable instructions. The database can store a control information sequence. The computer-readable instructions, when executed by the processor, can cause the processor to perform a method for constructing a light-emitting zone layout. The processor of the computer device is configured to provide computing and control capabilities and support the operation of the entire computer device. The memory of the computer device can store computer-readable instructions. The computer-readable instructions, when executed by the processor, can cause the processor to perform the method for constructing a light-emitting zone layout according to the present application. The network interface of the computer device is configured to connect to and communicate with a terminal. Those skilled in the art may understand that the structure shown in FIG. 17 is merely a block diagram of a partial structure related to the solutions of the present application, and does not constitute a limitation on the computer device to which the solutions of the present application are applied. The specific computer device may include more or fewer components than those shown in the figure, or combine certain components, or have a different component arrangement.

The present application further provides a storage medium storing computer-readable instructions. The computer-readable instructions, when executed by one or more processors, cause the one or more processors to perform the steps of the method for constructing a light-emitting zone layout described in any one of the embodiments of the present application.

The present application further provides a computer program product, including a computer program/instruction. The computer program/instruction, when executed by one or more processors, causes the one or more processors to perform the steps of the method for constructing a light-emitting zone layout described in any one of the embodiments of the present application.

In summary, according to the present application, a light strip model is abstracted from a light strip image for determining valid light positions of a light-emitting strip, and sequential position information of the valid light positions is constructed as a light-emitting zone layout. The construction of the light-emitting zone layout for the light-emitting strip achieves an easy-to-understand and easy-to-operate human-machine interaction function, can improve the configuration efficiency of the light-emitting strip, and makes such ambient light devices easier to promote and popularize.

Additionally, according to the present application, a light strip model is abstracted from a light strip image for determining sequential position information of light positions of a light-emitting strip. The construction of a light-emitting zone layout for the light-emitting strip achieves an easy-to-understand and easy-to-operate human-machine interaction function, can improve the configuration efficiency of the light-emitting strip, and makes such ambient light devices easier to promote and popularize.

## Claims

1. A method for constructing a light-emitting zone layout, comprising:
determining, based on a light strip image, a shaping path of a light-emitting strip and a plurality of light positions in the shaping path;
constructing a light strip model representing the shaping path and each of the light positions, and displaying the light strip model on an interface canvas for user editing; and
constructing, in response to a layout construction instruction, sequential position information of each of the light positions determined in the light strip model with reference to the interface canvas as a light-emitting zone layout of the light-emitting strip.

2. The method for constructing a light-emitting zone layout according to claim 1, wherein determining, based on the light strip image, the shaping path of the light-emitting strip and the plurality of light positions in the shaping path comprises:
starting a camera unit to collect the light strip image of the light-emitting strip in a lit state;
determining, based on the light strip image, a shaping region of the light-emitting strip in the light strip image to define the shaping path of the light-emitting strip, and extracting a light strip body image within the shaping region; and
identifying salient lighting features in the light strip body image, and determining positions where each of the salient lighting features is located as the corresponding light positions.

3. The method for constructing a light-emitting zone layout according to claim 2, wherein determining, based on the light strip image, the shaping region of the light-emitting strip in the light strip image to define the shaping path of the light-emitting strip comprises:
inputting the light strip image into a preset target detection model to detect a region image of the light-emitting strip in the light strip image; and
inputting the region image into a preset image segmentation model to identify the shaping region of the light-emitting strip in the region image, to define the shaping path of the light-emitting strip.

4. The method for constructing a light-emitting zone layout according to claim 1, wherein constructing the light strip model representing the shaping path and each of the light positions, and displaying the light strip model on the interface canvas for user editing comprises:
converting the shaping path into a vector curve;
adding, corresponding to a position of each of the light positions on the shaping path, a visual identifier corresponding to each of the light positions at a corresponding position on the vector curve; and
drawing the vector curve and the visual identifier onto the interface canvas to form the light strip model, and then rendering and displaying the light strip model.

5. The method for constructing a light-emitting zone layout according to claim 1, wherein constructing the sequential position information of each of the light positions determined in the light strip model with reference to the interface canvas as the light-emitting zone layout of the light-emitting strip comprises:
determining position information of each of the light positions based on coordinate information of each of the light positions in the light strip model relative to the interface canvas;
determining sequence information of each of the light positions based on an order of each of the light positions in the shaping path of the light strip model, wherein the order takes a signal input end in the shaping path as a sorting start end; and
combining the position information and the sequence information of each of the light positions into the sequential position information, and encapsulating the sequential position information of each of the light positions as the light-emitting zone layout of the light-emitting strip.

6. The method for constructing a light-emitting zone layout according to any one of claims 1 to 5, wherein prior to responding to the layout construction instruction, the method comprises:
identifying, based on the light strip image, a signal input end in the shaping path, and determining an order of each of the light positions by taking the signal input end as a sorting start end.

7. The method for constructing a light-emitting zone layout according to claim 6, wherein prior to responding to the layout construction instruction, the method comprises:
determining, in response to a light position calibration instruction, a light position designated by the instruction as a valid light position suitable for determining sequential position information.

8. A method for constructing a light-emitting zone layout, comprising:
constructing, based on a light strip image, a light strip model representing a shaping path of a light-emitting strip in the light strip image and each of light positions in the shaping path, and displaying the light strip model on an interface canvas;
determining, in response to a light position calibration instruction, light positions designated by the instruction as valid light positions; and
constructing, in response to a layout generation instruction, sequential position information of each of the valid light positions determined in the light strip model with reference to the interface canvas as a light-emitting zone layout of the light-emitting strip.

9. The method for constructing a light-emitting zone layout according to claim 8, wherein constructing, based on the light strip image, the light strip model representing the shaping path of the light-emitting strip in the light strip image and each of the light positions in the shaping path, and displaying the light strip model on the interface canvas comprises:
sending a lighting instruction to an ambient light device to control the light-emitting strip in the ambient light device to light up and present a preset light-emitting feature, wherein the lighting instruction contains light-emitting feature information corresponding to the light-emitting feature;
determining a shaping region of the light-emitting strip based on the light strip image photographed in a lit state of the light-emitting strip to define the shaping path of the light-emitting strip, and extracting a light strip body image within the shaping region;
identifying salient lighting features carried by the light-emitting feature in the light strip body image, and determining positions where each of the salient lighting features is located as the corresponding light positions; and
constructing the shaping path and each of the light positions as a light strip model, and displaying the light strip model on the interface canvas.

10. The method for constructing a light-emitting zone layout according to claim 9, wherein determining the shaping region of the light-emitting strip based on the light strip image photographed in the lit state of the light-emitting strip to define the shaping path of the light-emitting strip comprises:
inputting the light strip image into a preset target detection model to detect a region image of the light-emitting strip in the light strip image; and
inputting the region image into a preset image segmentation model to identify the shaping region of the light-emitting strip in the region image, to define the shaping path of the light-emitting strip.

11. The method for constructing a light-emitting zone layout according to claim 9, wherein constructing the shaping path and each of the light positions as the light strip model, and displaying the light strip model on the interface canvas comprises:
converting the shaping path into a vector curve;
adding, corresponding to a position of each of the light positions on the shaping path, a visual identifier corresponding to each of the light positions at a corresponding position on the vector curve; and
drawing the vector curve and the visual identifier onto the interface canvas to form the light strip model, and then rendering and displaying the light strip model.

12. The method for constructing a light-emitting zone layout according to claim 8, wherein determining, in response to the light position calibration instruction, the light positions designated by the instruction as the valid light positions comprises:
entering a manual editing mode in response to a key acting on a graphical user interface;
detecting a connecting operation acting on light positions in the light strip model, and triggering, in response to the connecting operation event, a light position calibration instruction; and
constructing, in response to the light position calibration instruction, a connection line connecting each of the light positions passed by the connecting operation, and identifying each of the light positions passed by the connection line as the valid light position.

13. The method for constructing a light-emitting zone layout according to claim 8, wherein constructing the sequential position information of each of the valid light positions determined in the light strip model with reference to the interface canvas as the light-emitting zone layout of the light-emitting strip comprises:
determining position information of each of the light positions based on coordinate information of each of the valid light positions in the light strip model relative to the interface canvas;
determining sequence information of each of the valid light positions based on an order of each of the valid light positions in the shaping path of the light strip model, wherein the order takes a signal input end in the shaping path as a sorting start end; and
representing, according to a preset format, the position information and the sequence information of each of the valid light positions as the sequential position information, and encapsulating the sequential position information of each of the valid light positions as the light-emitting zone layout of the light-emitting strip.

14. The method for constructing a light-emitting zone layout according to any one of claims 8 to 13, wherein prior to responding to the layout generation instruction, the method comprises:
identifying, based on the light strip image, a signal input end in the shaping path, and determining an order of each of the valid light positions by taking the signal input end as a sorting start end.

15. An ambient light device, comprising a controller and at least one light-emitting strip, wherein the controller is configured to receive a light-emitting zone layout generated by the method according to any one of claims 1 to 14, and control the light-emitting strip to play a lighting effect based on the light-emitting zone layout.

16. A computer device, comprising a central processing unit and a memory, wherein the central processing unit is configured to invoke and run a computer program stored in the memory to perform steps of the method according to any one of claims 1 to 14.

17. A non-volatile readable storage medium, wherein the non-volatile readable storage medium stores a computer program in a form of computer-readable instructions, and the computer program, when invoked and run by a computer, causes the computer to perform steps of the method according to any one of claims 1 to 14.

18. A computer program product, comprising a computer program, wherein the computer program, when run by a processor, causes the processor to perform steps of the method according to any one of claims 1 to 14.
